# EUROPEAN PATENT SPECIFICATION

(11) **EP 1 659 376 B1**
(45) Date of publication and mention of the grant of the patent: **28.05.2008**
(21) Application number: 05024577.8
(22) Date of filing: 10.11.2005
(51) Int. Cl.: G01D 11/24, H02K 5/15, H05K 5/02, H02K 5/16, F16C 17/00

(54) **Rotary electrical component**
Rotierendes elektrisches Bauteil
Composant électrique rotatoire

(30) Priority: 22.11.2004 JP 2004337450
(43) Date of publication of application: 24.05.2006
(73) Proprietor: ALPS ELECTRIC CO., LTD., Tokyo 145-8501 (JP)
(72) Inventor: Miyake, Toshikatsu, Tokyo 145-8501 (JP); Hosogoe, Junichi, Tokyo 145-8501 (JP)
(74) Representative: Klunker . Schmitt-Nilson . Hirsch

(56) References cited:
- EP-A- 0 566 088
- GB-A- 1 342 239
- US-A- 3 181 188
- US-A- 3 851 933
- US-A- 4 342 929
- US-A- 4 523 899
- US-A- 5 223 797
- US-A- 5 571 960
- US-A- 5 657 544
- US-A1- 2002 135 248

## Description

### BACKGROUND OF THE INVENTION

### 1. Field of the Invention

The present invention relates to a rotary electrical component such as an in-vehicle angle sensor.

### 2. Description of the Related Art

A typical rotary electrical component includes detecting means stored in a container section provided in a housing. A rotating shaft provided on an operating member extends through a shaft hole formed in the housing such that an end of the rotating shaft faces the container section. The operating member is externally rotated to activate the detecting means. The detecting means is generally of a contact type and includes a slider provided on the operating member and a resistor substrate fixed on the housing. However, non-contact detecting means using magnetic detection, optical detection, etc., is also known.

A bearing structure for use in such a rotary electrical component has been suggested in, for example, Japanese Unexamined Patent Application Publication No. 2000-292116 (see pages 4 to 6 and Fig. 1). According to this bearing structure, a cylindrical journal bearing is attached to a shaft hole by insert molding, and a rotating shaft of an operating member is rotatably supported on the bearing surface of the journal bearing.

In the above-described known rotary electrical component, a relatively long rotating shaft can be stably supported by using the cylindrical journal bearing. However, the bearing member is expensive since the journal bearing is made of a drawn material or a sintered material, and therefore the total cost is high.

A rotary electric component in accordance with the preamble of claim 1 is known from US-A-5,571,960. The prior art component comprises a housing made of synthetic resin and including a cylindrical bearing portion. GB-13 42 239 discloses a thrust roller bearing intended to be used in a clutch mechanism of a motor car. A side plate of the bearing is integrally formed with a casing that surrounds the outer raise of the bearing.

### SUMMARY OF THE INVENTION

In light of the above-described situation, an object of the present invention is to provide a rotary electrical component that can reduce the total cost thereof by using inexpensive bearing members.

To achieve the above-described object, a rotary electrical component according to the present invention includes a housing made of synthetic resin, the housing having a shaft hole and a container section that communicates with the shaft hole; an operating member that has a rotating shaft extending through the shaft hole and that rotates a driving portion disposed in the container section with the rotating shaft; and a pair of bearing members supporting the rotating shaft such that the rotating shaft can rotate in the shaft hole. Each of the bearing members includes a plate bearing composed of a metal plate and having a guide projection along the rim of a circular hole formed in the plate bearing. The plate bearings are fixed to the housing at positions near open ends of the shaft hole so that an outer peripheral surface of the rotating shaft slides along the guide projections of the plate bearings at axial ends of the rotating shaft.

In the rotary electrical component that is structured as described above, the rotating shaft of the operating member is stably supported by a pair of plate bearings that can be produced from a metal plate at a low cost. Therefore, the total cost of the rotary electrical component can be reduced.

In the above-described structure, each of the plate bearings preferably has a plurality of retaining lugs along the outer rim thereof, the retaining lugs being press-fitted to the housing. In such a case, the plate bearings can be easily and reliably assembled to the housing.

In addition, in the above-described structure, when the rotary electrical component is, for example, an in-vehicle angle sensor that requires high airtightness, the container section preferably has a sealed structure and the housing has a recess at one or each of the open ends of the shaft hole, the recess being formed continuously from the corresponding open end, receiving a rubber ring for seal that is in tight contact with the outer peripheral surface of the rotating shaft, and being covered with one of the plate bearings at the corresponding open end. In such a case, the plate bearings serve not only as the bearing members, but also as members for preventing the rubber ring from being lost. Therefore, the airtight structure is made simpler.

According to the present invention, a rotary electrical component is structured such that a rotating shaft of an operating member is stably supported by a pair of plate bearings. Since the plate bearings can be produced from a metal plate at a low cost, the total cost of the rotary electrical component can be reduced.

### BRIEF DESCRIPTION OF THE DRAWINGS

Fig. 1 is a sectional view of a rotary electrical component according to an embodiment of the present invention;
Fig. 2 is an exploded perspective view of the rotary electrical component; and
Fig. 3 is a perspective view of a plate bearing included in the rotary electrical component.

### DESCRIPTION OF THE PREFERRED EMBODIMENT

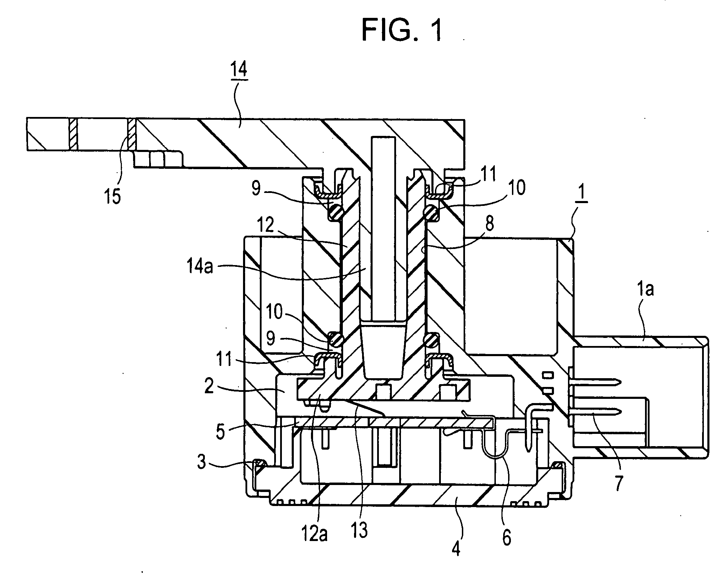

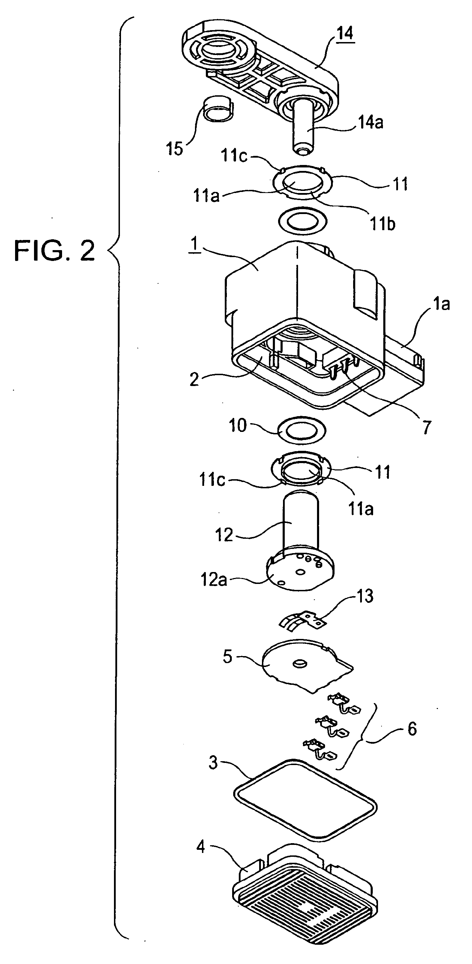

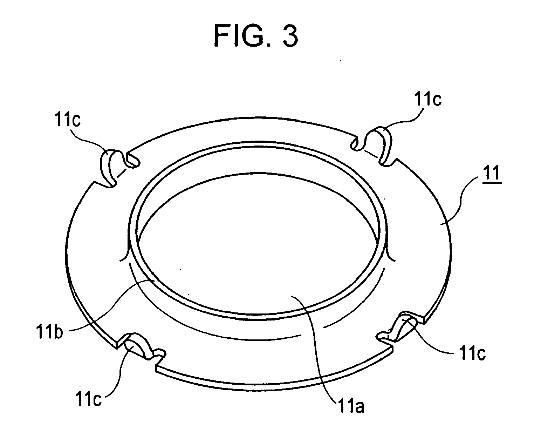

An embodiment of the present invention will be described below with reference to the drawings. Fig. 1 is a sectional view of a rotary electrical component according to an embodiment of the present invention. Fig. 2 is an exploded perspective view of the rotary electrical component. Fig. 3 is a perspective view of a plate bearing included in the rotary electrical component.

The rotary electrical component according to the present embodiment is, for example, an in-vehicle angle sensor that detects a torque generated when a steering wheel is turned, and includes a housing 1 made of synthetic resin that is attached to a vehicle at a predetermined position. A container section 2 having an open end at the bottom in the figures is provided in the housing 1, and a cover 4 made of synthetic resin is attached to the container section 2 with a rubber ring 3 for seal disposed therebetween so as to cover the open end of the container section 2. A resistor substrate 5 is stored and retained in the container section 2. The resistor substrate 5 has a resistor layer (not shown), a current collector layer (not shown), and a plurality of terminals 6 connected to the resistor layer and the current collector layer. In addition, a plurality of external terminals 7 are insert-molded in the housing 1. Each external terminal 7 projects into a connector unit 1a at one end thereof, the connector unit 1a being formed integrally on a side of the housing 1. The other end of each external terminal 7 is connected to the corresponding terminal 6 in the container section 2.

The housing has a relatively long shaft hole 8 that communicates with the container section 2 and step-shaped recesses 9 are formed continuously from top and bottom open ends of the shaft hole 8. Each of the recesses 9 has a small-diameter portion in which an O-ring (rubber ring) 10 for seal is disposed and a large-diameter portion to which a bearing member 11 is fixed. The bearing members 11 serve to prevent the O-rings 10 from being lost. As shown in Fig. 3, each bearing member 11 is a plate bearing obtained by press-forming a metal plate made of stainless steel or the like into a ring shape, and has a circular hole 11a at the center. A guide projection 11b is formed along the rim of the circular hole 11a by a burring process. In addition, a plurality of retaining lugs 11c are formed on the outer rim of the bearing member 11 by a bending process. The retaining lugs 11c are press-fitted to the peripheral wall of the large-diameter portion of the corresponding recess 9, so that the bearing member 11 is securely fixed to the housing 1.

A rotating shaft 12 made of synthetic resin is inserted into the shaft hole 8. The outer peripheral surface of the rotating shaft 12 slides along the guide projections 11b of the housings 11 at both axial ends of the rotating shaft 12, so that the rotating shaft 12 is rotatably supported by the bearing members 11. In addition, the O-rings 10 are in tight contact with the outer peripheral surface of the rotating shaft 12, so that the gap that is necessary between the shaft hole 8 and the rotating shaft 12 is sealed by the O-rings 10 to ensure airtightness. A driving portion 12a that rotates in the container section 2 is formed integrally with the rotating shaft 12 at the bottom end thereof in the figures, and a slider 13 that slides along the resistor layer and the current collector layer of the resistor substrate 5 is attached to the driving portion 12a. The resistor substrate 5 and the slider 13 form detecting means. The rotating shaft 12 has a hollow structure with an opening at the top end in the figures. A connecting pin 14a that is formed integrally with an operating member 14 made of synthetic resin is inserted into the hollow section of the rotating shaft 12 and is fixed so as to integrate the hollow section of the rotating shaft 12. Thus, the operating member 14 and the rotating shaft 12 are integrated with each other. Although not shown in the figures, the connecting pin 14a may have grooves for retaining grease. A bush 15 made of metal is press-fitted in the operating member 14, and a detection object (not shown) is connected to the bush 15 so that the operating member 14 rotates together with the rotation of the detection object.

In the rotary electrical component that is constructed as described above, the operating member 14 is rotated by an external driving force, and accordingly the rotating shaft 12 rotates while sliding along the guide projections 11b of the bearing members 11. The slider 13 attached to the driving portion 12a rotates while sliding along the resistor layer (not shown) of the resistor substrate 5, so that a variation in the relative position between them is output from each external terminal 7 as an electric signal.

In the rotary electrical component according to the present embodiment, the relatively long rotating shaft 12 that is integrated with the operating member 14 is stably supported by the pair of bearing members 11 at both ends thereof. The bearing members 11 are inexpensive plate bearings obtained by press-forming a metal plate into a ring shape. Accordingly, the total cost can be reduced compared to that of the known structure using a journal bearing. In addition, the retaining lugs 11c are formed by a bending process on the outer rims of the bearing members 11 composed of the plate bearings and are press-fitted to the peripheral walls of the large-diameter portions of the recesses 9. Accordingly, the bearing members 11 can be easily and securely fixed to the housing 1.

In addition, in the rotary electrical component according to the present embodiment, the open end of the container section 2 is sealed by the rubber ring 3 and the cover 4 and the gap between the rotating shaft 12 and the shaft hole 8 that communicates with the container section 2 is sealed with the pair of O-rings 10. Therefore, the container section 2 that stores the detecting means has high airtightness. In addition, since the O-rings 10 are disposed in the small-diameter portions of the step-shaped recesses 9 and are covered by the bearing members 11 fixed to the large-diameter portions of the recesses 9, the bearing members 11 composed of plate bearings serve a function of preventing the O-rings 10 for seal from being lost. Therefore, the airtight structure is made simpler.

In the above-described embodiment, the in-vehicle angle sensor is explained as a rotary electrical component according to the present invention. However, the present invention may, of course, be applied also to other rotary electrical components, including throttle valve sensors and the like.

## Claims

1. A rotary electrical component comprising
a housing (1) made of synthetic resin, the housing (1) having a shaft hole (8) and a container section (2) that communicates with the shaft hole (8); and
an operating member (14) that has a rotating shaft (12) extending through the shaft hole (8) and that rotates a driving portion (12a) disposed in the container section (2) with the rotating shaft (12); **characterized by**
a pair of bearing members (11) supporting the rotating shaft (12) such that the rotating shaft (12) can rotate in the shaft hole (8),
wherein each of the bearing members (11) includes a plate bearing composed of a metal plate and having a guide projection (11b) along the rim of a circular hole (11a) formed in the plate bearing, and
wherein the plate bearings are fixed to the housing (1) at positions near open ends of the shaft hole (8) so that an outer peripheral surface of the rotating shaft (12) slides along the guide projections (11b) of the plate bearings (11) at axial ends of the rotating shaft (12), and wherein one of the plate bearings (11) supports the rotation of the operating member (14), and the other one of the plate bearing (11) supports the rotation of the rotating shaft (12) that rotates together with the operating member (14).

2. The rotary electrical component according to claim 1, wherein each of the plate bearings (11) has plurality of wherein each of the plate bearings has a plurality of retaining lugs (11c) along the outer rim thereof,the retaining lugs (11c) being press-fitted tp the housing (1).

3. The rotary electrical component according to one of claims 1 and 2, wherein the container section (2) has a sealed structure and the housing has a recess at one or each of the open ends of the shaft hole (8), the recess being formed continuously from the corresponding open end, receiving a rubber ring (10) for seal that is in tight contact with the outer peripheral surface of the rotating shaft (12), and being covered with one of the plate bearings at the corresponding open end.

## Revendications

1. Composant électrique à rotation comprenant :
un boîtier (1) fait de résine synthétique, le boîtier (1) comportant un trou d'axe (8) et une section de coque (2) qui communique avec le trou d'axe (8) ; et
un organe fonctionnel (14) comportant un axe rotatif (12) s'étendant à travers le trou d'axe (8) et faisant tourner une partie de commande (12a) disposée dans la section de coque (2) avec l'axe rotatif (12) ;
**caractérisé par**
une paire d'organes d'appui (11) supportant l'axe rotatif (12), tels que l'axe rotatif (12) peut tourner dans le trou d'axe (8),
dans lequel chacun des organes d'appui (11) comporte un appui plat constitué d'une plaque métallique et comportant une protubérance de guidage (11b) le long du bord d'un trou circulaire (11a) formé dans l'appui plat, et
dans lequel les appuis plats sont fixés au boîtier (1) dans des positions proches des extrémités ouvertes du trou d'axe (8) de sorte que la surface périphérique externe de l'axe rotatif (12) glisse le long des protubérances de guidage (11b) des appuis plats (11) aux extrémités axiales de l'axe rotatif (12), et dans lequel l'un des appuis plats (11) supporte la rotation de l'organe fonctionnel (14) est l'autre appui plat (11) supporte la rotation de l'axe rotatif (12) qui tourne avec l'organe fonctionnel (14).

2. Composant électrique à rotation selon la revendication 1, dans lequel chacun des appuis plats (11) comporte une pluralité d'ergots de maintien (11b) le long de son rebord externe, les ergots de maintien (11c) étant ajustés par pression sur le boîtier (1).

3. Composant électrique à rotation selon l'une des revendications 1 et 2, dans lequel la section de coque (2) possède une structure étanche et le boîtier comporte une cavité sur l'une ou sur chacune des extrémités ouvertes du trou d'axe (8), la cavité étant formée en continu depuis l'extrémité ouverte correspondante, recevant une bague en caoutchouc (10) pour l'étanchéité, qui est en contact étroit avec la surface périphérique externe de l'axe rotatif (12), et qui est recouverte de l'une des plaques d'appui à l'extrémité ouverte correspondante.

## Patentansprüche

1. Drehbares elektrisches Bauteil, aufweisend:
ein Gehäuse (1) aus Kunstharz, wobei das Gehäuse (1) eine Schaftöffnung (8) und einen Behältnisbereich (2) aufweist, der mit der Schaftöffnung (8) in Verbindung steht; und
ein Betätigungselement (14), das einen sich durch die Schaftöffnung (8) hindurch erstreckenden drehbaren Schaft (12) aufweist und das einen in dem Behältnisbereich (2) angeordneten Antriebsbereich (12a) mittels des drehbaren Schafts (12) rotationsmäßig bewegt;
**gekennzeichnet durch**
ein Paar Lagerelemente (11), die den drehbaren Schaft (12) derart abstützen, dass sich der drehbare Scahft (12) in der Schaftöffnung (8) drehen kann,
wobei jedes der Lagerelemente (11) ein Plattenlager beinhaltet, das aus einer Metallplatte gebildet ist und einen Führungsvorsprung (11b) entlang des Rands einer in dem Plattenlager ausgebildeten kreisförmigen Öffnung (11a) aufweist, und
wobei die Plattenlager an dem Gehäuse (1) an Stellen in der Nähe von offenen Enden der Schaftöffnung (8) festgelegt sind, so dass eine Außenumfangsfläche des drehbaren Schafts (12) eine Gleitbewegung entlang der Führungsvorsprünge (11b) der Plattenlager (11) an den axialen Enden des drehbaren Schafts (12) ausführt,
und wobei das eine Plattenlager (11) die Rotationsbewegung des Betätigungselements (14) abstützt und das andere Plattenlager (11) die Rotationsbewegung des drehbaren Schafts (12) abstützt, der sich zusammen mit dem Betätigungselement (14) rotationsmäßig bewegt.

2. Drehbares elektrisches Bauteil nach Anspruch 1,
wobei jedes der Plattenlager (11) eine Mehrzahl von Festhaltezungen (11c) entlang seines äußeren Rands aufweist, wobei die Festhaltezungen (11c) im Presssitz an dem Gehäuse (1) angebracht sind.

3. Drehbares elektrisches Bauteil nach einem der Ansprüche 1 und 2,
wobei der Behältnisbereich eine abgeschlossene Ausbildung aufweist und das Gehäuse eine Aussparung an einem oder jedem der offenen Enden der Schaftöffnung (8) aufweist, wobei die Aussparung von dem entsprechenden offenen Ende in kontinuierlicher Weise ausgebildet ist, einen Gummiring (10) als Dichtung aufnimmt, der in engem Kontakt mit der Außenumfangsfläche des drehbaren Schafts (12) steht, sowie von einem der Plattenlager an dem entsprechenden offenen Ende überdeckt ist.
